(19) **Europäisches Patentamt / European Patent Office / Office européen des brevets**

(11) **EP 1 744 460 A1**

(12) # EUROPEAN PATENT APPLICATION

(43) Date of publication:
**17.01.2007 Bulletin 2007/03**

(51) Int Cl.:
**H03M 1/68** (2006.01)   **H03F 1/26** (2006.01)

(21) Application number: **05106360.0**

(22) Date of filing: **12.07.2005**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(71) Applicant: **TOWN CROFT LIMITED**
**Dublin 6 (IE)**

(72) Inventor: **Caroni, Stefano**
**6965 Cadro (CH)**

(74) Representative: **Gervasi, Gemma**
**Studio Brevetti e Marchi**
**NOTARBARTOLO & GERVASI S.r.l.,**
**Corso di Porta Vittoria, 9**
**20122 Milano (IT)**

(54) **Amplifier for electrical parameters measurement apparatuses**

(57)    The object of the present invention refers to an amplifier for electrical parameters measurement apparatuses that allows the amplification of the electrical signal to be measured and reject the noise connected with the electronic components of the measuring system thanks to an architecture combining A/D and D/A conversions.

EP 1 744 460 A1

**Description**

*Field of the invention*

This invention refers to the field of the apparatuses for the measurement of electrical parameters.

*State of the art*

The use of amplifiers in high precision apparatuses for the measurement of electrical parameters such as current and voltage is well know.

Normally amplifiers are a very important and sensitive part of a design because their performances strongly affect the performances of the whole apparatuses they work in

Amplifiers may operate in noisy environment therefore they amplify the noise present at their input terminals together with the signal they were intended to work with. Furthermore, amplification factor may be influenced by electromagnetic field so the gain is variable and the output signal is corrupted by noise.

Usually shielding and filtering are techniques employed to overcome the problems of noise amplification but they have several drawback such as higher costs, extra design effort, difficulties of implementation, etc.

The amplifier, according to the present invention, overcome the above technical problems of the state of the art of apparatuses for the measurement of electrical parameters by means an architecture that allows the amplification of the electrical signal to be measured and reject the noise connected with the electronic components of the measuring system.

*Summary*

The amplifier for electrical parameters measurement according to the present invention overcomes the technical problems of the state of the art regarding the apparatuses for the measurement of electrical parameters, introducing a topology employing two converters (A/D and D/A) that are less noise-sensitive and can operate in presence of strong electromagnetic fields.

*Brief description of the drawings*

Fig. 1 shows a block diagram of a preferred configuration of the amplifier for electrical parameters measurement apparatuses according to the present invention.
Fig. 2 shows a block diagram of a first preferred configuration of the differential amplifier for electrical parameters measurement apparatuses according to the present invention.
Fig. 3 shows a block diagram of a second preferred configuration of the amplifier for electrical parameters measurement apparatuses according to the present invention.

*Detailed description of the invention*

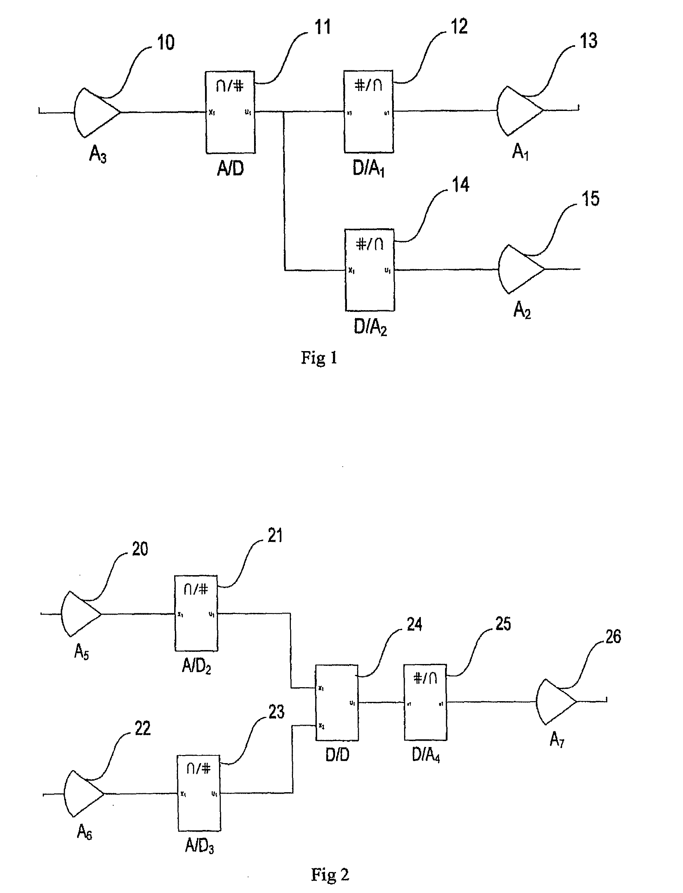

With reference to Fig. 1, a block diagram of a preferred configuration of the amplifier for electrical parameters measurement apparatuses according to the present invention is depicted.

An input electrical signal Vi associated to an electrical parameter to be measured is amplified by an analog amplifier 10.

The amplified signal A3Vi is sampled and converted in digital format by an A/D converter 11.

The A/D converter 11 converts the signal A3Vi in a sequence of a certain number of bits depending on its resolution. Assuming the resolution of the A/D converter 11 to be sixteen bits and the amplitude of the analog signal to be converted (A3Vi) to have an max amplitude of ten Volts, the resolution of the A/D converter 11 is equal to:

$$R1 = A3Vi_{MAX}/2^{16} = 152 * 10^{-6} \text{ Volts.}$$

The information we are looking for is normally associated to the micro variation of the input signal.

The least significant bits of the digital output signal of the A/D converter 11 describe the micro variations of the input signal. On the other side, if we are interested in amplifying a big signal, it is possible to evade the effect of noise, amplifying only the most significant bits of the digital output of the A/D converter 11.

The least significant part of the digital output signal of the A/D converter 11 is then sent to a D/A converter 12.

Assuming that the above least significant part corresponds to the ten least significant bit word generated by the A/D converter, its amplitude is equal to:

$$A3Vip = R1 * 2^{10} = 155,6 * 10^{-3} \text{ Volts.}$$

Were A3Vip is the greatest input signal A3Vi

The D/A converter 12 amplifies the voltage at its input, A3Vip by a coefficient:

$$E_{3,1} = V_y / A3Vip = R1 / R2$$

Where R2 is the resolution of the D/A converter 12 and $V_y$ is the voltage at its output.

Assuming $V_y$, output of the D/A converter 12, equal to A3Vi, input voltage of the A/D converter 11, implies that

$$E_{3,1} = 2^6$$

Voltage $V_y$ is than amplified by analog amplifier 13 in order to have an output analog voltage

$$Vu1 = Vi * E_{3,1} * A3 *A1$$

The resolution R1 of A/D converter 11 needs to be greater than the resolution R2 of the D/A converter 12.

On the other side, if we are interested in measuring a big signal, it is possible to evade the effect of noise considering only the most significant bits of the digital output of the A/D converter 11.

An electrical input signal Vi associated to an electrical parameter to be measured is amplified by an analog amplifier 10.

The amplified signal A3Vi is sampled and converted in digital format by an A/D converter 11.

The A/D converter 11 converts the signal A3Vi in a sequence of a certain number of bits depending on its resolution. Assuming that the above most significant part corresponds to the six most significant bit word generated by the A/D converter, the range of admittable values is:

$$A3Vi_{min} = R1 * 2^{10} ;$$

$$A3Vi_{MAX} = R1 * 2^{16} ;$$

Assuming that the max input voltage of A/D converter 11, $A3V_{MAX}$, is equal to the maximum output voltage of D/A converter 14, Vy, the amplification factor due to the two conversions is:

$$E_{3,2} = V_y / A3V_{MAX} = 1$$

Voltage $V_y$ is than amplified by analog amplifier 15 in order to have the desired amplitude analog output voltage.

Fig. 2 illustrates a second preferred embodiment of the present invention that performs a differential amplifier for electrical parameters measurement.

This configuration allows the measurement of the difference of two input signal, Vi 1 and Vi2.

The voltage signals Vi1 and Vi2 are amplified by analog amplifiers, respectively 20 and 22, and then converted in digital format by A/D converters, respectively 21 and 23.

The least significant bits of the signals Vi1 and Vi2, indicated in Fig. 2 as Vi1A5p and Vi2A6p are processed by an electronic D/D circuit 24, which performs the subtraction of the two input signals. The output signal of electronic D/D circuit 24 is processed by the D/A converter 25 and amplified by the analog amplifier 26 in order to have, as a result of this processing, an analog output resulting from the differential amplification of the two input signal.

In the above-described configuration of the present invention, to obtain a digital amplification of the input signal, the resolution of D/A converter 25 must be higher than the resolution of both the A/D converters 21 and 23.

The amplification factor of the presented configuration is evaluated similarly to the description of previous configuration.

Assuming:

$$R1 = V_y / 2^{16} \; ; R2 = V_y / 2^{10}$$

can obtain:

$$E_{3,1} = 2^6$$

The voltage output signal Vd is:

$$Vd = (Vi1 - Vi2) * E_{3,1} * A5 * A$$

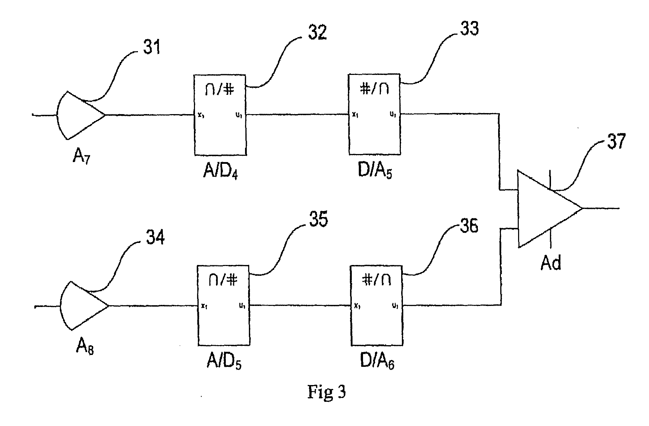

In a further preferred configuration, depicted in Fig. 3, the voltage signals Vi1 and Vi2 are amplified by analog amplifier 31 and 34 respectively.

Then they are converted in digital format by the A/D converter 32 and 35.

The least significant part of the two digital outputs of A/D converters are then reconverted by D/A converter 33 and 36.

Differential amplification is implemented by the analog differential amplifier 37.

The amplification factor of presented configuration is evaluated similarly to the description of previous configuration.

Assuming:

$$R1 = V_y / 2^{16} \; ; R2 = V_y / 2^{10}$$

can obtain:

$$E_{3,1} = 2^6$$

The voltage output signal Vd is:

$$Vd = (Vi1 - Vi2) * E_{3,1} * A5 * Ad$$

**Claims**

1.  Amplifier for electrical parameters measurement comprising at least one A/D converter and at least one D/A converter **characterised in that** said at least one D/A converter input is a part of the output of said at least one A/D converter.

2. Amplifier for electrical parameters measurement according to claim 1 **characterised in that** said part of the output of said at least one A/D converter is the most significant part or the least significant part.

3. Amplifier for electrical parameters measurement according to claim 1-2 **characterised in that** the resolution of said at least one D/A converter is lower than the resolution of said at least one A/D converter.

4. Amplifier for electrical parameters measurement according to claim 1 - 3 **characterised in that** it comprises at least one D/D processing device

5. Amplifier for electrical parameters measurement according to claim 1 - 3 **characterised in that** it comprises one input terminal, two output terminals, three analog amplifiers (10, 13, 15), one A/D converter (11) and two D/A converter (12, 14)

6. Amplifier for electrical parameters measurement according to claim 5 **characterised in that** said input terminal is connected to the input terminal of the first of said three analog amplifiers (10, 13, 15), the output terminal of the first of said three analog amplifiers (10, 13, 15) is connected to the input terminal of said A/D converter (11), the output terminal of said A/D converter (11) is connected to the input terminals of said two D/A converter (12, 14), the output terminals of said two D/A converter (12, 14) are connected to the input terminals of the second and the third of said three analog amplifiers (10, 13, 15) and the output terminals of the second and the third of said three analog amplifiers (10, 13, 15) are connected to said two output terminals of said amplifier for electrical parameters measurement.

7. Amplifier for electrical parameters measurement according to claim 1 - 4 **characterised in that** it comprises two input terminals, one output terminal, three analog amplifiers (20, 22, 26), two A/D converters (21, 23), one digital subtractor (24) and one D/A converter (25)

8. Amplifier for electrical parameters measurement according to claim 7 **characterised in that** said two input terminals are connected to the input terminals of two of said three analog amplifiers (20, 22, 26), the output terminals of two of said three analog amplifiers (20, 22, 26) are connected to the input terminals of said two A/D converters (21, 23), the output terminals of said two A/D converters (21, 23) are connected to the input terminals of said one digital subtractor (24), the output terminal of said one digital subtractor (24) is connected to the input terminals of said one D/A converter (25), the output terminal of said one D/A converter (25) is connected to the input terminal of the third of said three analog amplifiers (20, 22, 26) and the output terminal of the third of said three analog amplifiers (20, 22, 26) is connected to said one output terminal of said amplifier for electrical parameters measurement.

9. Amplifier for electrical parameters measurement according to claim 1 - 3 **characterised in that** it comprises two input terminals, one output terminal, two analog amplifiers (31, 34), two A/D converters (32, 35), two D/A converters (33, 36) and one analog differential amplifier (37).

10. Amplifier for electrical parameters measurement according to claim 9 **characterised in that** said two input terminals are connected to the input terminals of said two analog amplifiers (31, 34), the output terminals of said two analog amplifiers (31, 34) are connected to the input terminals of said two A/D converters (32, 35), the output terminals of said two A/D converters (32, 35) are connected to the input terminals of said two D/A converters (33, 36), the output terminals of said two D/A converters (33, 36) are connected to to the input terminals of said one analog differential amplifier (37) and the output terminal of said one analog differential amplifier (37) is connected to said one output terminal of said amplifier for electrical parameters measurement.

11. Method for electrical parameters measurement **characterised in that** it comprises the following steps:

   a) analog amplification of the input signals
   b) analog to digital conversion of the signals resulting from step a)
   c) optional digital processing of the most significant part or the least significant part of the digital signal resulting from step b)
   d) digital to analog conversion of the most significant part or the least significant part of the digital signal resulting from step b) or digital to analog conversion of the digital signal resulting from step c)
   e) analog amplification of the signals resulting from step d)

12. Method for electrical parameters measurement according to claim 11 **characterised in that** it is performed by an amplifier for electrical parameters measurement according to claims 1 - 10

Fig 1

Fig 2

Fig 3

European Patent
Office

**EUROPEAN SEARCH REPORT**

Application Number

EP 05 10 6360

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | PATENT ABSTRACTS OF JAPAN<br>vol. 006, no. 100 (P-121),<br>9 June 1982 (1982-06-09)<br>& JP 57 033404 A (MITSUBISHI ELECTRIC CORP), 23 February 1982 (1982-02-23)<br>* abstract * | 1,11,12 | INV.<br>H03M1/68<br>H03F1/26 |
| X | GB 2 195 855 A (THE * PLESSEY COMPANY PLC; * THE PLESSEY COMPANY PLC)<br>13 April 1988 (1988-04-13)<br>* figure 1 * | 1,4 | |
| X | PATENT ABSTRACTS OF JAPAN<br>vol. 005, no. 052 (P-056),<br>11 April 1981 (1981-04-11)<br>& JP 56 007030 A (FUJITSU LTD),<br>24 January 1981 (1981-01-24)<br>* abstract * | 1,11,12 | |
| X | EP 1 172 928 A (INTRACOM S.A. HELLENIC TELECOMMUNICATIONS & ELECTRONICS INDUSTRY)<br>16 January 2002 (2002-01-16)<br>* figure 1 * | 1,11,12 | TECHNICAL FIELDS SEARCHED (IPC)<br>H03M<br>H03F |
| X | PATENT ABSTRACTS OF JAPAN<br>vol. 007, no. 075 (P-187),<br>29 March 1983 (1983-03-29)<br>& JP 58 005615 A (HOKUSHIN DENKI SEISAKUSHO:KK),<br>13 January 1983 (1983-01-13)<br>* abstract * | 1,11,12 | |
| A | GB 2 164 511 A (ERIC ANDREW * FAULKNER)<br>19 March 1986 (1986-03-19)<br>* figure 2 * | 1-3,11,12 | |

~~The present search report has been drawn up for all claims~~

| Place of search | Date of completion of the search | Examiner |
|---|---|---|
| Munich | 19 December 2005 | Kurzbauer, W |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

European Patent

Office

Application Number

EP 05 10 6360

## CLAIMS INCURRING FEES

The present European patent application comprised at the time of filing more than ten claims.

☐ Only part of the claims have been paid within the prescribed time limit. The present European search report has been drawn up for the first ten claims and for those claims for which claims fees have been paid, namely claim(s):

☐ No claims fees have been paid within the prescribed time limit. The present European search report has been drawn up for the first ten claims.

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☒ None of the further search fees have been paid within the fixed time limit. The present European search report has been drawn up for those parts of the European patent application which relate to the invention first mentioned in the claims, namely claims:

1-3,11,12

**European Patent Office**

**LACK OF UNITY OF INVENTION SHEET B**

Application Number

EP 05 10 6360

The Search Division considers that the present European patent application does not comply with the requirements of unity of invention and relates to several inventions or groups of inventions, namely:

1. claims: 1-3,11,12

   Amplifier comprising an A/D converter and a D/A converter wherein the input of the D/A converter is a part of the output of said A/D converter, whereby the resolution of the D/A converter is lower than the resolution of the A/D converter.
   ---

2. claim: 4

   Amplifier comprising an A/D converter and a D/A converter wherein the input of the D/A converter is a part of the output of said A/D converter wherby the amplifier comprises a digital processing device.
   ---

3. claims: 5-6

   Amplifier comprising an A/D converter and a D/A converter wherein the input of the D/A converter is a part of the output of said A/D converter, whereby the amplifier comprises three analog amplifiers one ADC and two DACs.
   ---

4. claims: 7,8

   Amplifier comprising an A/D converter and a D/A converter wherein the input of the D/A converter is a part of the output of said A/D converter, whereby the amplifier comprises three analog amplifiers two ADCs and one DAC and a digital subtractor.
   ---

5. claims: 9,10

   Amplifier comprising an A/D converter and a D/A converter wherein the input of the D/A converter is a part of the output of said A/D converter, whereby the amplifier comprises three analog amplifiers two ADCs and two DACs and one analog differential amplifier.
   ---

**ANNEX TO THE EUROPEAN SEARCH REPORT
ON EUROPEAN PATENT APPLICATION NO.**                EP 05 10 6360

This annex lists the patent family members relating to the patent documents cited in  the above-mentioned European search report.
The members are as contained in the European Patent Office EDP file on
The European Patent Office is in no way liable for these particulars which are merely  given for the purpose of information.

19-12-2005

| Patent document cited in search report | | Publication date | Patent family member(s) | | Publication date |
|---|---|---|---|---|---|
| JP 57033404 | A | 23-02-1982 | NONE | | |
| GB 2195855 | A | 13-04-1988 | NONE | | |
| JP 56007030 | A | 24-01-1981 | JP | 1420855 C | 29-01-1988 |
|  |  |  | JP | 62028845 B | 23-06-1987 |
| EP 1172928 | A | 16-01-2002 | GR | 1003688 B1 | 05-10-2001 |
| JP 58005615 | A | 13-01-1983 | NONE | | |
| GB 2164511 | A | 19-03-1986 | EP | 0236315 A1 | 16-09-1987 |
|  |  |  | WO | 8701887 A1 | 26-03-1987 |

EPO FORM P0459

For more details about this annex : see Official Journal of the European Patent Office, No. 12/82